# EUROPEAN PATENT APPLICATION

(11) **EP 1 001 667 A2**
(43) Date of publication of application: **17.05.2000**
(21) Application number: 99122691.1
(22) Date of filing: 15.11.1999
(51) Int. Cl.: H05K 3/34, H05K 3/12

(54) **Method for maintaining the printability of a solder paste**

(30) Priority: 16.11.1998 US 192356
(71) Applicant: PRAXAIR TECHNOLOGY, INC., Danbury, CT 06810-5113 (US)
(72) Inventor: Nowotarski, Mark Stephen, Stanford, Connecticut 06906 (US); Presti, Michael J., Stamford, Connecticut 06907 (US); Mackie, Andrew Christopher, Highland Mills, New York 10930-2811 (US)
(74) Representative: Schwan, Ivo, Dipl.-Ing. (FH)

(57) **Abstract**

This invention is directed to a method for maintaining the printability of a solder paste by flowing a gas which contains a controlled amount of a solvent vapor adjacent to the paste and absorbing an effective amount of the solvent into the paste.

## Description

### FIELD OF THE INVENTION

This invention relates to a method for stabilizing the rheological properties of a solvent-containing material, such as a paste or ink. More specifically, this invention relates to a method for maintaining the printability of a solder paste.

### BACKGROUND OF THE INVENTION

Inks are suspensions of solid pigment particulates in a viscous vehicle. Solder paste (also known as "solder cream") is a mixture of solder metal particulates (typically from 84% to 91% by weight metal) in a viscous vehicle referred to as "flux". The flux vehicle in solder paste may typically comprise from 25% to greater than about 80%, by weight, of a potentially volatile solvent or solvent mixture.

A list of other materials used in the flux usually includes, but is not limited to: resins, rosins, thixotropes, activators and corrosion-inhibitors.

The printing of solder paste onto a substrate is one of the key aspects of the development of surface mount technology (SMT). It is well-known in the industry, for example, that a large percentage (typically 30-40%) of the defects found in completed electronic assemblies manufactured using SMT, may be attributed to inconsistencies during the process of printing solder paste onto the surface of the bare printed circuit board. See, Anson et al., "Qualifying a High-Rel No-clean Process" in 'Guide to Soldering Materials' [Special Supplement to SMT Magazine] (November 1997).

The majority of printing defects observed are characterized by variations in the printing properties of the solder paste with time. Several patents have been issued on processes intended to make the printing of inks or solder pastes invariant with time. Each of these processes is based on one of three theories expounded to explain the variation of the printing properties with time. These theories are: 1) evaporation of solvent from the flux vehicle leads to increases in paste viscosity; 2) reaction of the solder paste with oxygen or other reactive gases in the atmosphere causes viscosity increases; and 3) absorption of water vapor causes the paste to either harden, due to chemical reactions, or spread ('slump'), caused by reduced paste viscosity, caused by the absorption of solvent (usually water) vapor.

The patents that fit into the former category, specifically, evaporation of solvent from the flux vehicle leads to increases in paste viscosity, include U.S. Patent No. 5,410,957, which discloses the use of an airtight compartment over the solder paste, which becomes saturated with solvent vapor from the ink or paste vehicle. This '957 patent does not maintain the rheological properties of a vehicle containing a high-volatility solvent, or a vehicle that is very sensitive to small changes in the solvent content, since the sole source of the solvent vapor is the ink itself. Also, there is no teaching or suggestion in the '957 patent for the use of an inert gaseous atmosphere.

U.S. Patent No. 4,729,306 discloses a sealed chamber over a screen onto which solvent may be sprayed to assist in printing for inks. This patent discloses the addition of liquid solvent to the ink itself, not to the vapors. Also, there is no teaching or suggestion in the '306 patent for the use of an inert gaseous atmosphere.

Great Britain Patent No. 2,298,393 discloses the use of a sealed chamber, for maintaining the printing materials (i.e., solder paste) in "a deactivated state" including the use of an "inert gas, such as nitrogen". The '393 patent has the same drawback as the '957 patent, in that no extra solvent or solvent vapor is added to compensate for that evaporating from the ink or paste itself, to saturate the atmosphere.

U.S. Patent No. 4,637,308 discloses a substantially closed box within which is a means of passively providing solvent vapor into the gaseous environment within the box, to extend the screen-life of printing inks. The '308 patent does not teach or suggest the use of an inert atmosphere, or a means of controlling the vapor pressure in the gaseous atmosphere adjacent to the ink.

A patent that fits into the second category, specifically, reaction of the solder paste with atmospheric gases causes viscosity increases, includes U.S. Patent No. 4,545,300, which discloses a sealed printing apparatus (frame, screen and chamber) capable of being flooded with an inert gas (both nitrogen and carbon dioxide are mentioned), and thus replacing the oxygen and preventing the ink from changing its rheological properties due to chemical reactions. The '300 patent does not teach or suggest using a flow of gas over the ink. Although the '300 patent discloses spraying solvents into a sealed chamber, reference is made only to solvent in a dispersed liquid (rather than vapor/gaseous) form.

The use of a wet nitrogen storage system that keeps the paste wet, tacky and oxide-free has been known. See, Condon (Electronic Packaging And Production, January 1987, pp. 64-65). The equipment is for the storage of circuit boards that have already been printed with solder paste, but have not yet had components placed on the surface. The set-up is described as a sealed cabinet or desiccator, with a slight nitrogen flow. A solvent vapor may be provided by a simple dish of the paste solvent or a container with a towel-type wick. Gas cannot, of course, flow into a hermetically sealed chamber without a constant rise in pressure in the chamber; thus the slight nitrogen flow referred to is necessary to produce a small positive pressure in the chamber in case of small leaks. This gas flow, therefore, does not provide a means of controlling the vapor pressure of solvent to a certain level (as in the present invention). Instead, it simply excludes air from the system. The degree to which the vapor pressure of solvent can be controlled in such a manner is also likely to be small since the cabinet doors are large and will need to be opened frequently to place and retrieve circuit boards.

Japanese Kokai Patent Application Number Hei 8[19961-279671 discloses a method of providing a paste with stable printing characteristics over a period of time of exposure to air. The partial pressure of solvent in a paste is lower than that in the external atmosphere. This Kokai patent does not teach that an excessively high solvent vapor pressure can cause slumping or other deleterious conditions in the solder paste. Further, this Kokai patent also does not teach the use of an inert or unreactive gas as the carrier gas for the solvent vapor, or the use of a flow of said carrier gas.

### OBJECT OF THE INVENTION

It is an object to provide a method for maintaining the printability of a solder paste.

It is a further object to provide a means of extending the time that an ink or paste may be left exposed to a gaseous atmosphere without changes in its rheological properties.

It is a further object to provide a method for protecting the surface of a particulate suspension in a viscous vehicle from a reactive gaseous atmosphere.

### BRIEF DESCRIPTION OF THE DRAWINGS

Fig. 1 is a diagrammatic representation of a lengthwise cross-section through one embodiment of the vapor control unit;
Fig. 2 is a diagrammatic representation of a lengthwise cross-section through one embodiment of the atmospheric retention unit for a screen or stencil printer;
Fig. 3 is a diagrammatic representation of a lengthwise cross-section through one embodiment of the atmospheric retention unit for storage of printed substrates, or solder-printing stencils and other printing materials; and
Fig. 4 is a detailed representation of the underside of one embodiment of the atmospheric retention unit for a screen or stencil printer.

### SUMMARY OF THE INVENTION

This invention is directed to a method for maintaining the printability of a solder paste in an ambient environment, comprising flowing an inert gas, which contains a controlled amount of vapor of a solvent or a mixture of solvents, over the paste and absorbing an effective amount of the solvent into the paste, such that the amount of solvent or solvents absorbed by the paste is substantially equal to the amount of solvent or solvents evaporating from the paste.

In particular, the flowing of the vapor-doped gas maintains the mass of the paste constant by keeping the partial vapor pressure of the solvent in the flowing gas essentially the same as that of the solvent vapor in the paste.

In another embodiment, the method involves controlling the flow rate of a vapor-doped carrier gas and controlling the vapor pressure of solvent in that gas. The solvent may comprise an amount of substituted solvent vapor. The gas may comprise nitrogen.

For the purpose of this invention, various terms are defined as follows:

The term "solvent" as used herein refers to a liquid material that may either be present in the flux vehicle, or that may be added to the said vehicle, that dissolves materials present in the said vehicle. The word 'solvent' in this instance, therefore, explicitly includes water, along with various other inorganic or organic substances.

"Ambient environment" shall mean a non-airtight system. This shall include the environment generally found for the practice of printing using solder paste.

"Inert (carrier) gases" shall mean non-reactive gases known to those skilled in the art, but shall not be limited to nitrogen and argon. As explained before, the word 'inert' may generally only be used in reference to a specific ink or paste system.

The list of "solvents" includes, but is not limited to water, diethylene glycol dibutyl ether, diethylene glycol monobutyl ether, diethylene glycol, poly(ethylene glycol) dimethyl ether, dipropylene glycol, dipropylene glycol monomethyl ether, alpha-terpineol, 1-methyl-2-pyrrolidinone, tetrahydrofurfuryl alcohol.

The term "inks and pastes" includes, but is not limited to printing inks, solder pastes, conductive adhesives, adhesives, inks, paints and any other materials where a comminuted solid phase is dispersed in a solvent-containing liquid phase.

The term "printability" refers to the efficacy of the ink or paste, for example, in the action of printing process onto a substrate.

The term "substitute solvent" refers to a solvent that is either not present, or not present in appreciable quantities, in the original ink or paste. The vapor of this "substitute solvent" condenses on the surface of the ink or paste vehicle, replacing the solvent in the ink or paste at substantially the same rate that the original solvent volatilizes away from the vehicle.

### DETAILED DESCRIPTION OF THE INVENTION

The method uses a flow of inert gas containing a controlled amount of solvent vapor(s), which passes over the exposed surface of the ink or paste.

The present invention introduces some new technical aspects of the art not previously described, which are 1) a flow of vapor-doped carrier gas over the ink or paste surface; 2) active control of both the flow rate of the vapor-doped carrier gas and the concentration of vapor or vapors in the vapor-doped carrier gas; and 3) the vapor of a substitute solvent.

The substitute solvent may be chosen in such a way that some of its chemical properties are similar to those of the original solvent that is volatilizing away from the paste.

The substitute solvent may also act via hydrogen bonding or other physico-chemical means to slow down the volatilization of the solvent already present in the paste.

The "drying out" of the ink or paste has already been described. The process known as "concretion" involves solidification of the ink or paste due to chemical reactions. It should be noted that the presence of excessive amounts of solvent may also have a deleterious effect on the performance characteristics of a paste or ink, thus if the vapor pressure of the solvent component of the gaseous atmosphere over an exposed ink or paste surface exceeds the partial vapor pressure of the solvent component of the vehicle, then this will lead to absorption of solvent vapor by the vehicle. The rheological properties of the ink or paste may then change, leading to a deterioration of the printing properties and/or spreading of material beyond the printed area (so-called "slump")

Control of the vapor pressure of the solvent is therefore a vital aspect of any process designed to stabilize the rheological properties of inks and pastes exposed to a gaseous environment.

The invention provides a means of making the printing of inks or pastes (most particularly, but not limited to, solder pastes) insensitive to deleterious effects caused by contact with the local gaseous environment. This is carried out by using a flow of a vapor-doped inert carrier gas over the ink or paste. This gas flow performs two functions: it (1) continually excludes the local air (along with its content of gases and vapors which may cause performance degradation), and (2) provides a localized atmospheric environment whereby the evaporation rate of solvent or solvents in the carrier vehicle is reduced to practically zero. That is, if the vapor pressure of solvent or solvents in the gaseous atmosphere immediately adjacent to the ink or paste matches that of the solvent or solvents dissolved in the ink or paste vehicle, then the solvent and its vapor are in equilibrium, and there will be no change in the solvent content of the vehicle (or paste) over a period of time.

Based on rheological, or similar, experiments with the desired ink or paste in contact with a gaseous atmosphere, it may readily be deduced whether the gaseous atmosphere has any specific deleterious chemical or physical effects on the ink or paste being studied. If changes in the rheology are found to be a result of solvent evaporation, then there is no 'specific' reaction with the gas or gas mixture. If the gaseous atmosphere has no specific effects of the type just described, then it may be referred to as an "inert gas" or "inert carrier gas", but only in association with that particular ink or paste.

There are a number of advantages for the current invention: a significant reduction in the number of defects in the final product that can be attributed to changes in the printing characteristics of the ink or paste over time; a reduction in waste in the process for manufacturing ink and paste as above by extending the 'life' of the ink or paste; in the printing application, the entire printing process can be readily inspected while maintaining an inert atmosphere (this allows the operator to check for correct 'rolling' or other print-characteristics, if defects are observed after this process step); finally, the flow of gas at room temperature over the surface of the ink or paste material will allow the material to maintain its temperature more consistently than in an enclosed environment. This is particularly important in the case of viscous materials, which become heated simply by the action of printing.

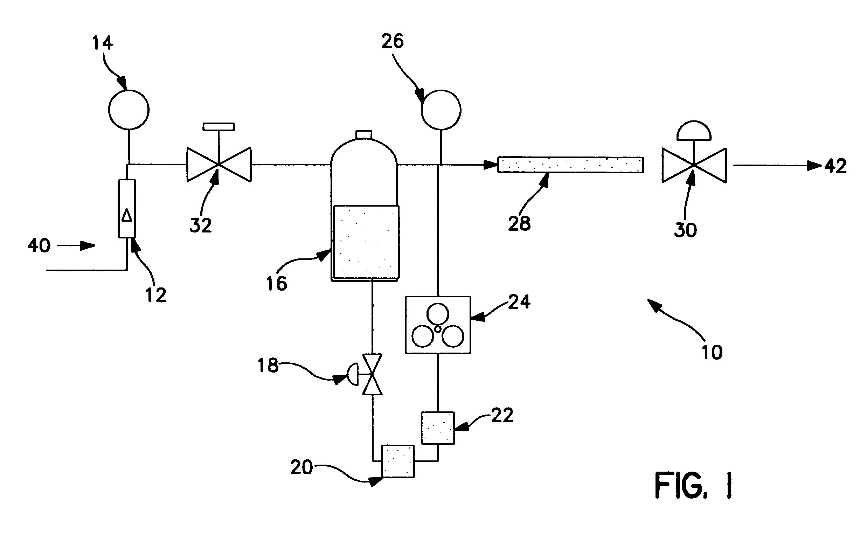

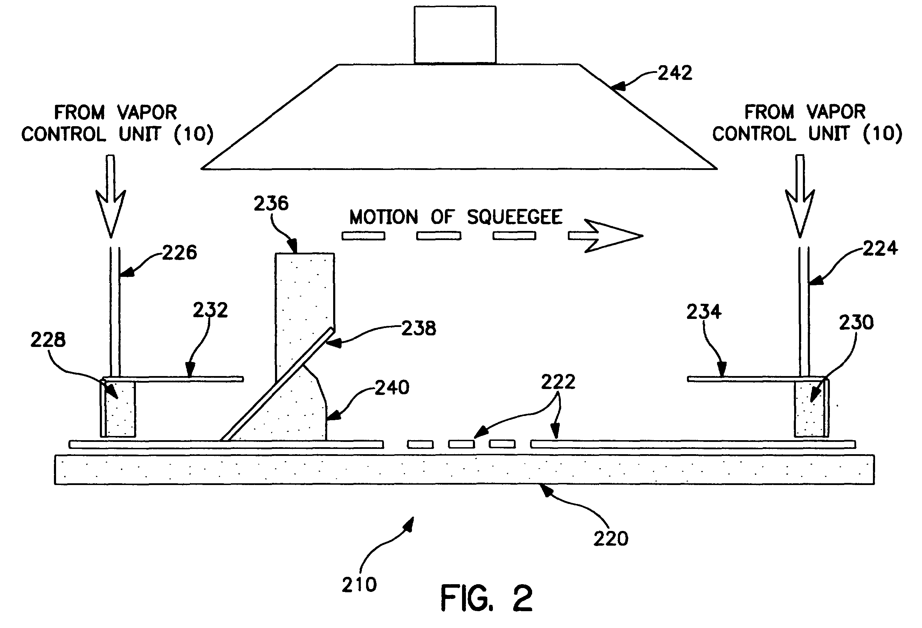

The part of the invention described hereinafter as the "vapor control unit" is shown in Fig. 1. The vapor control unit provides a means of controlling both the flow rate of carrier gas, and the concentration of vapor or vapors in the said carrier gas. The resulting stream of vapor-doped carrier gas then passes to the part of the invention described hereinafter as the "atmospheric retention unit" (Figs. 2, 3 and 4), which provides a means of delivering the said vapor-doped carrier gas to the surface of the paste or ink in contact with the potentially deleterious gaseous environment.
Fig. 1 is a diagrammatic representation of a lengthwise cross-section through one potential embodiment of the vapor control unit 10. Inert gas 40 passes through the flow meter 12 into the solvent vessel 16, at a rate governed by the needle valve 32. The pressure is monitored by the pressure indicator 14. Solvent is withdrawn from the bottom of the solvent vessel 16 by the action of a displacement pump 24, which draws solvent through two filters 20 and 22. A ball valve 18 is provided to shut the solvent supply off, if needed. The displacement pump 24 then dispenses metered aliquots of liquid solvent into the stream of gas. The pressure at this point may be monitored by a pressure indicator 26. The gas/solvent mixture passes through a solvent/gas contactor 28, which allows the solvent to evaporate fully, so no liquid passes into the atmosphere retention unit 42. A ball valve 30 is provided to shut the gas supply off, if needed.
Fig. 2 is a diagrammatic representation of a lengthwise cross-section through one potential embodiment of the atmospheric retention unit 210 for a screen or stencil printer, where a substrate 220 (for example, a printed circuit board), is to be printed with solder paste 240. In addition, the screen or stencil 230, tubes 224 and 226 from the output of the vapor control unit (Fig. 1), gas-diffusers 228 and 230, the framework 232 and 234 of the atmospheric retention unit, squeegee-holder 236, squeegee 238, roll 240 of ink or paste all are part of the atmospheric retention unit 210. The framework 232 and 234 may or may not be physically connected. An exhaust hood 242 removes the carrier gas and some solvent vapors to either a solvent-recovery system (such as a carbon-filter or a cryogenic unit) . The vapors may also be burned, or simply passed to the outside air.

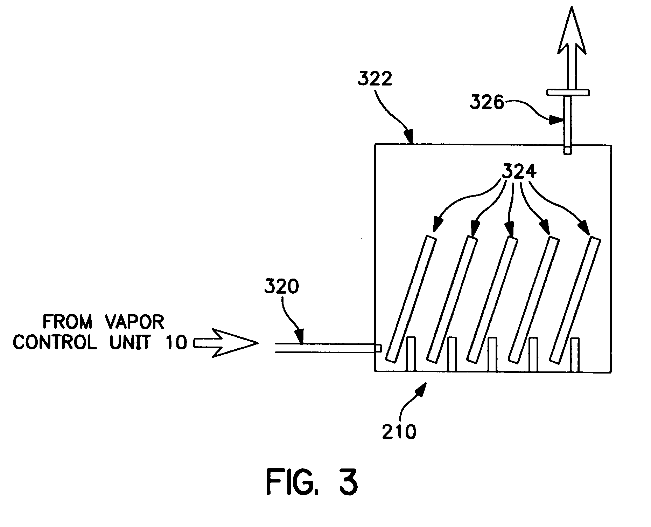

Fig. 3 is a diagrammatic representation of a lengthwise cross-section through one potential embodiment of the atmospheric retention unit 210 for storage of printed substrates. A tube 320 from the output of the vapor-control unit 10 feeds gas from box 322 wherein printed substrates 324 are stored. Tube 326 leads to the exhaust from atmospheric retention unit 210.

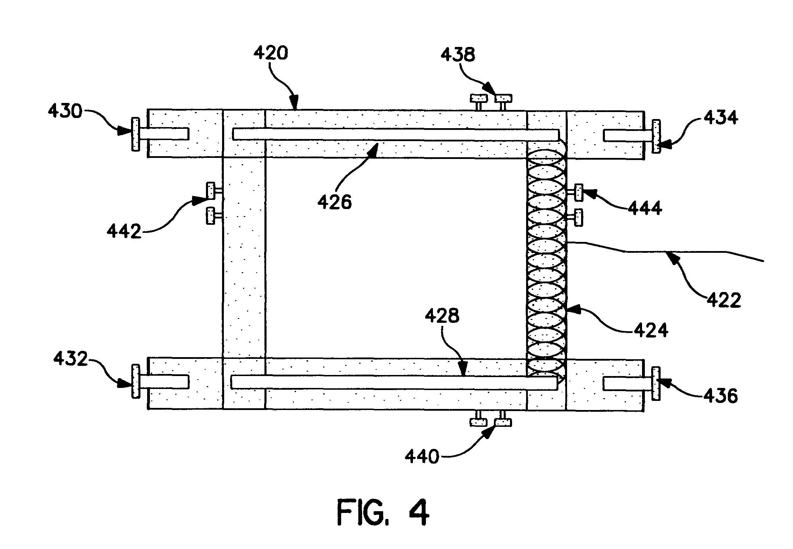

Fig. 4 is a more detailed representation of the underside of one embodiment of the atmospheric retention unit 210 for a screen or stencil printer, where an adjustable frame 420 can be expanded in the x and y directions, to fit onto a variety of stencil shapes and sizes, to maintain the required atmosphere around the exposed surface of the paste or ink being printed. A flexible piping system, containing tubes 422 and 424, supplies the controlled vapor atmosphere from the vapor-control unit to two (2) rod-shaped diffusers 426 and 428, which allow a laminar flow of gas to pass over the material being printed. Adjustable bolts 430, 432, 434 and 436 allow the frame to be attached to different sizes of stencil frame 420. Bolts 438, 440, 442 and 444 slide in slots in the adjustable frame 420, to allow it to be expanded, or contracted, as required.

It may readily be seen that there is a variety of alternative means of practicing the ideas described here. These include an alternative means of supplying solvent vapor, in the vapor-control unit by (1) bubbling (sparging) gas into a container of solvent; and (2) using pieces of fabric, or a series of capillary tubes, with their lower end in a container of solvent, and their upper end exposed to the flowing carrier-gas stream, with capillary action maintaining a constant flow of solvent to the upper end. In this instance, the rate of solvent evaporation into the stream of carrier gas could be controlled by adjusting either the width of the fabric, or the number of capillary tubes.

Another means of practicing the present invention is through the design of the atmospheric retention unit itself, which may be adapted for a variety of uses, as has already been explained. When used in conjunction with the printing process, the atmospheric retention unit may be readily designed to be either i) a temporary (see Fig. 2) or ii) a permanent attachment to the foil of a stencil or the emulsion-screen, or its frame.

Although the invention primarily covers the printing process, it may be extended to cover any part of a process where an ink, paste, or similar material is exposed to a gaseous atmosphere. This includes operations such as (1) circuit boards printed with solder paste or conductive adhesive, before or after the component placement operation, but prior to reflow/curing; or (2) manufacture, storage and packaging of printing ink, solder paste or conductive adhesive on a large or small scale.

Specific features of the invention are shown in one or more of the drawings for convenience only, as each feature may be combined with other features in accordance with the invention. Alternative embodiments will be recognized by those skilled in the art and are intended to be included within the scope of the claims.

## Claims

1. A method for maintaining the printability of a solder paste in an ambient environment comprising flowing an inert gas, which contains a controlled amount of a solvent vapor, adjacent to said paste, and thereby absorbing an effective amount of said solvent into said paste such that the amount of said solvent being absorbed into said paste is substantially equal to the amount of solvent evaporated from said paste.

2. The method of claim 1 wherein flowing of said gas maintains the mass of said paste substantially constant, by keeping the partial vapor pressure of the solvent in said paste substantially in equilibrium with the partial vapor pressure of the solvent in said gas.

3. The method of claim 1 wherein said passing of said flow of said gas involves controlling the flow rate of a vapor-doped carrier gas and controlling the vapor pressure of said vapor-doped carrier gas.

4. The method of claim 1 wherein said solvent comprises an amount of substituted solvent vapor.

5. The method of claim 1 wherein said gas comprises nitrogen.
